(19) Europäisches Patentamt
European Patent Office
Office européen des brevets

(11) **EP 3 117 021 B1**

(12) **EUROPÄISCHE PATENTSCHRIFT**

(45) Veröffentlichungstag und Bekanntmachung des Hinweises auf die Patenterteilung:
**06.06.2018 Patentblatt 2018/23**

(51) Int Cl.:
**C23C 16/34** *(2006.01)*  **C23C 16/36** *(2006.01)*

(21) Anmeldenummer: **15709872.4**

(22) Anmeldetag: **03.03.2015**

(86) Internationale Anmeldenummer:
**PCT/EP2015/054450**

(87) Internationale Veröffentlichungsnummer:
**WO 2015/135802 (17.09.2015 Gazette 2015/37)**

(54) **TIALCN-SCHICHTEN MIT LAMELLENSTRUKTUR**

TIALCN LAYERS WITH LAMELLAR STRUCTURE

COUCHES DE TIALCN AYANT UNE STRUCTURE LAMELLAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.03.2014 DE 102014103220**

(43) Veröffentlichungstag der Anmeldung:
**18.01.2017 Patentblatt 2017/03**

(73) Patentinhaber: **Walter AG**
**72072 Tübingen (DE)**

(72) Erfinder:
• **STIENS, Dirk**
**72076 Tübingen (DE)**
• **MANNS, Thorsten**
**72074 Tübingen (DE)**
• **RUPPI, Sakari**
**8500-308 Portimao (PT)**

(74) Vertreter: **WSL Patentanwälte Partnerschaft mbB**
**Kaiser-Friedrich-Ring 98**
**65185 Wiesbaden (DE)**

(56) Entgegenhaltungen:
**EP-A1- 0 496 516    WO-A1-2013/134796**

**Beschreibung**

**Gegenstand der Erfindung**

Die Erfindung betrifft ein Werkzeug mit einem Grundkörper aus Hartmetall, Cermet, Keramik, Stahl oder Schnellarbeitsstahl und einer darauf im CVD-Verfahren aufgebrachten ein- oder mehrlagigen Verschleißschutzbeschichtung mit einer Dicke im Bereich von 3 $\mu$m bis 25 $\mu$m, wobei die Verschleißschutzbeschichtung wenigstens eine $Ti_{1-x}Al_x$-$C_yN_z$-Lage mit Stöchiometriekoeffizienten $0{,}70 \leq x < 1$, $0 \leq y < 0{,}25$ und $0{,}75 \leq z < 1{,}15$ und mit einer Dicke im Bereich von 1,5 $\mu$m bis 17 $\mu$m aufweist. Weiterhin betrifft die Erfindung ein Verfahren zur Herstellung eines solchen Werkzeugs.

**Hintergrund der Erfindung**

Schneideinsätze für die Werkstoffbearbeitung, insbesondere für die zerspanende Metallbearbeitung, bestehen aus einem Substratkörper aus Hartmetall, Cermet, Keramik, Stahl oder Schnellarbeitsstahl, der in den meisten Fällen zur Verbesserung der Schneid- und/oder Verschleißeigenschaften mit einer ein- oder mehrlagigen Hartstoffbeschichtung versehen ist. Die Hartstoffbeschichtung besteht aus übereinander angeordneten Lagen monometallischer oder gemischtmetallischer Hartstoffphasen. Beispiele für monometallische Hartstoffphasen sind TiN, TiC, TiCN und $Al_2O_3$. Beispiele für gemischtmetallische Phasen, bei denen in einem Kristall ein Metall teilweise durch ein anderes ersetzt ist, sind TiAlN und TiAlCN. Beschichtungen der vorgenannten Art werden durch CVD-Verfahren (chemische Dampfphasenabscheidung), PCVD-Verfahren (Plasma-unterstützte CVD-Verfahren) oder durch PVD-Verfahren (physikalische Dampfphasenabscheidung) aufgebracht.

Es hat sich gezeigt, dass bestimmte Vorzugsorientierungen des Kristallwachstums bei der Abscheidung im PVD- oder CVD-Verfahren besondere Vorteile haben können, wobei für unterschiedliche Anwendungen des Schneideinsatzes auch unterschiedliche Vorzugsorientierungen bestimmter Lagen einer Beschichtung besonders vorteilhaft sein können. Die Vorzugsorientierung des Wachstums wird in der Regel in Bezug auf die über die Miller-Indizes definierten Ebenen des Kristallgitters angegeben und als kristallographische Textur (z. B. Fasertextur) bezeichnet.

Die WO 2013/134796 offenbart einen Schneideinsatz, der zumindest bereichsweise eine Beschichtung aufweist, die aus einer oder mehreren Beschichtungslagen gebildet ist, wobei zumindest eine Beschichtungslage Aluminium, Titan und Stickstoff umfasst und zumindest teilweise Lamellen mit einer Lamellendicke von weniger als 100 nm aufweist, wobei die Lamellen abwechselnde erste und zweite Abschnitte mit unterschiedlichen Phasen umfassen, wobei die ersten Abschnitte überwiegend oder ausschließlich aus harter kubischer Phase bestehen und die zweiten Abschnitte überwiegend oder ausschließlich aus weicher hexagonaler Phase bestehen. Dabei soll das Wechselspiel zwischen der Abfolge einer harten kubischen Phase und einer weicheren hexagonalen Phase die Festigkeit aufgrund der speziellen Ausbildung der Struktur im Nanometer-Bereich begünstigen, wobei der weichere hexagonale Anteil überwiegt. Es zeigt sich jedoch, dass Schichten mit Anteilen an hexagonaler Phase besonders in der Fräs- oder Drehbearbeitung von Stahl und Gusswerkstoffen bei hohen Schnittgeschwindigkeiten eine unzureichende Verschleissfestigkeit aufweisen.

Die WO 2012/126030 offenbart einen Schneideinsatz mit einer mehrlagigen Beschichtung, die wenigstens eine Beschichtungslage mit $Al_xTi_{1-x}N$ mit $x \geq 0{,}7$ aufweist, wobei der Anteil an kubischer $Al_xTi_{1-x}N$-Phase bevorzugt 70 bis 80 Mol-% beträgt und die übrigen Anteile von hexagonalem AlN und kubischem TiN gebildet werden. Der Anteil an hexagonalem AlN beträgt vorzugsweise mehr als 12,5 Mol-%. Auch die Verschleissbeständigkeit solcher Beschichtungen ist aufgrund des Anteils an hexagonalem AlN ungenügend. Es wird angenommen, dass das Vorhandensein der drei genannten Phasen auf einer teilweisen Zersetzung der kubischen $Al_xTi_{1-x}N$-Phase in die thermodynamisch stabilen hexagonalen AlN- und kubischen TiN-Phasen beruht und der verbleibende Anteil an kubischer $Al_xTi_{1-x}N$-Phase nicht nur thermodynamisch, sondern auch kinetisch instabil ist, was zu einer weiteren Zersetzung führt, wodurch es zu einer mechanischen Schwächung der Schicht kommt.

J. Keckes et al., "Self-organized periodic soft-hard nanolamellae in polycrystalline TiAlN thin films", Thin Solid Films 545 (2013), Seiten 29-32, beschreiben mittels CVD abgeschiedene polykristalline $Ti_{0.05}Al_{0.95}N$-Lagen mit periodisch alternierenden kubischen TiN- und hexagonalen AlN-Nanolamellen innerhalb einzelner Kristallite. Als ein möglicher Mechanismus der Lamellenbildung werden kinetisch kontrollierte, oszillierende Reaktionen an der Abscheidungsoberfläche vorgeschlagen. Die $Ti_{0.05}Al_{0.95}N$-Lagen wurden im MT-CVD-Verfahren bei 800°C unter anderem auf Hartmetallsubstraten abgeschieden. Die Charakterisierung der Lagen erfolgte mittels Röntgendiffraktion (XRD) und konventioneller sowie hochauflösender Transmissionselektronenmikroskopie (TEM und HR-TEM). Die XRD-Daten der abgeschiedenen $Ti_{0.05}Al_{0.95}N$-Lagen zeigten das Vorhandensein sowohl kubischer als auch hexagonaler Ti-Al-N-Phasen. Pulverröntgenbeugungsanalysen des $Ti_{0.05}Al_{0.95}N$-Materials und eine quantitative Rietveld-Analyse ergaben Volumenanteile von hexagonalem AlN (w-AlN), kubischem AlN (c-AlN) und kubischem TiN (c-TiN) von etwa 53, 26 und 21%. Die Härte der Lage betrug etwa 28 GPa. Die TEM-Analyse an Querschnitten der $Ti_{0.05}Al_{0.95}N$-Lagen auf Hartmetall zeigten das Vorhandensein lamellarer periodischer Strukturen. Mittels HR-TEM und Fourier-Transformation (FFT) konnte gezeigt werden, dass die Lamellen periodisch abwechselnd c-TiN und w-AlN aufwiesen, wobei die w-AlN enthaltenden Lamellen etwa 10nm und die c-TiN enthaltenden Lamellen etwa 3nm dick waren. Bei diesen Schichten ist wegen des hohen Gehaltes an hexagonaler w-AlN Phase ebenfalls mit einer unzureichenden Verschleissbeständigkeit zu rechnen.

Die DE 10 2005 032 860 offenbart eine Hartstoffbeschichtung mit einer Lage aus kubisch flächenzentriertem $Ti_{1-x}Al_xN$ mit einem Al-Gehalt von $0,75 < x < 0,93$ und ein Verfahren zu deren Herstellung.

Die DE 10 2007 000 512 offenbart eine Hartstoffbeschichtung mit einer Lage aus TiAlN, die auf einer unmittelbar auf dem Substrat abgeschiedenen ersten Lage aus TiN, TiCN oder TiC und einer zwischen den beiden Lagen vorgesehenen Anbindungslage mit einem Phasengradienten abgeschieden ist. Die Lage aus TiAlN weist eine Vorzugsorientierung des Kristallwachstums bezüglich der (200)-Ebene des Kristallgitters auf.

Die Offenlegungsschriften WO 2009/112115, WO 2009/112116 und WO 2009/112117A1 offenbaren mittels CVD-Verfahren abgeschiedene TiAlN- und TiAlCN-Lagen mit hohem Al-Anteil und kubisch flächenzentriertem Gitter, jedoch sind keine kristallographischen Vorzugsorientierungen des Kristallwachstums beschrieben.

Mittels PVD-Verfahren hergestellte TiAlN-Beschichtungen mit verschiedenen kristallographischen Vorzugsorientierungen des Kristallwachstums sind bekannt, jedoch sind PVD-Beschichtungen mit kubisch flächenzentriertem Gitter der TiAlN-Beschichtungen im Gegensatz zu CVD-Beschichtungen auf Al-Gehalte von weniger als 67 % beschränkt. TiAlN-Beschichtungen mit einer kristallographischen Vorzugsorientierung der {200}-Ebene bezüglich der Wachstumsrichtung der Kristallite werden als vorteilhaft für die Metallbearbeitung beschrieben (z. B. US 2009/0274899, US 2009/0074521 und WO 2009/127344).

## Aufgabe

Die Aufgabe der vorliegenden Erfindungen bestand in der Bereitstellung von Schneideinsätzen für die spanende Metallbearbeitung, insbesondere die Dreh- und Fräsbearbeitung von Stahl- oder Gusswerkstoffen, die eine gegenüber dem Stand der Technik verbesserte Verschleißbeständigkeit und verbesserte Beständigkeit gegen thermische Rissbildung aufweisen.

## Beschreibung der Erfindung

Gelöst wird diese Aufgabe durch ein Werkzeug mit einem Grundkörper aus Hartmetall, Cermet, Keramik, Stahl oder Schnellarbeitsstahl und einer darauf im CVD-Verfahren aufgebrachten ein- oder mehrlagigen Verschleißschutzbeschichtung mit einer Dicke im Bereich von 3 $\mu$m bis 25 $\mu$m, wobei die Verschleißschutzbeschichtung wenigstens eine $Ti_{1-x}Al_xC_yN_z$-Lage mit Stöchiometriekoeffizienten $0,70 \leq x < 1$, $0 \leq y < 0,25$ und $0,75 \leq z < 1,15$ und mit einer Dicke im Bereich von 1,5 $\mu$m bis 17 $\mu$m aufweist, dadurch gekennzeichnet, dass

- die $Ti_{1-x}Al_xC_yN_z$-Lage eine lamellare Struktur besitzt mit Lamellen mit einer Dicke von nicht mehr als 150 nm, vorzugsweise nicht mehr als 100 nm, besonders bevorzugt nicht mehr als 50 nm, wobei
- die Lamellen aus periodisch alternierenden Bereichen der $Ti_{1-x}Al_xC_yN_z$-Lage mit abwechselnd unterschiedlichen stöchiometrischen Anteilen an Ti und Al gebildet sind, welche die gleiche Kristallstruktur (kristallographische Phase) aufweisen, und
- die $Ti_{1-x}Al_xC_yN_z$-Lage wenigstens 90 Vol.-% kubisch flächenzentrierte (fcc) Kristallstruktur aufweist.

Die Lamellen aus periodisch alternierenden Bereichen der erfindungsgemäßen $Ti_{1-x}Al_xC_yN_z$-Lage mit abwechselnd unterschiedlichen Ti- und Al-Anteilen weisen die gleiche kubisch flächenzentrierte (fcc) Kristallstruktur auf. Es wurde überraschend festgestellt, dass eine solche lamellare Struktur beträchtlich höhere Standzeiten des Werkzeugs in Schneidoperationen liefert als lamellare TiAlN- oder TiAlCN-Strukturen mit alternierenden Kristallstrukturen, wie beispielsweise die aus dem Stand der Technik bekannten lamellaren Strukturen mit abwechselnd kubisch flächenzentrierten und hexagonalen Kristallstrukturen der Lamellen.

Die erfindungsgemäße $Ti_{1-x}Al_xC_yN_z$-Lage weist wenigstens 90 Vol.-% kubisch flächenzentrierte (fcc) Kristallstruktur auf. Ist der Anteil an $Ti_{1-x}Al_xC_yN_z$-Phase mit kubisch flächenzentriertem (fcc) Gitter zu gering, wird eine geringere Verschleißbeständigkeit beobachtet.

Ein noch höherer Anteil an $Ti_{1-x}Al_xC_yN_z$ mit kubisch flächenzentrierter (fcc) Kristallstruktur hat sich als vorteilhaft hinsichtlich der Verschleißbeständigkeit erwiesen. In einer bevorzugten Ausführungsform der Erfindung weist die $Ti_{1-x}Al_xC_yN_z$-Lage daher wenigstens 95 Vol.-%, vorzugsweise wenigstens 98 Vol.-%, besonders bevorzugt etwa 100 Vol.-% kubisch flächenzentrierte (fcc) Kristallstruktur auf.

Die Kristallmorphologie der polykristallinen $Ti_{1-x}Al_xC_yN_c$-Lage kann kolumnar (säulenförmig) oder äquiaxial sein, wobei die kolumnare Morphologie bevorzugt ist, da diese gegenüber äquiaxialer Morphologie in der Regel den Vorteil hat, dass im Zerspanprozess eine höhere Beständigkeit gegen Freiflächenverschleiß beobachtet wird. Es stehen bei kolumnarer Mikrostruktur parallel zur Schichtoberfläche weniger Korngrenzen zur Verfügung, entlang derer die Kristallite in der Schicht bei der auftretenden mechanischen Beanspruchung gleiten oder ausbrechen können. Kolumnare Kristalle wachsen mit ihrer Längsachse im Wesentlichen senkrecht zur Oberfläche des Substrates. Die Breite der kolumnaren Kristalle wird in einer Richtung parallel zur Substratoberfläche gemessen, d. h. senkrecht zur Wachstumsrichtung der Kristalle. Die Breite der Kristalle ist nicht zwingend uniaxial, sondern kann in verschiedenen Richtungen parallel zur Substratoberfläche variieren. Die Messung der Länge und Breite der Kristalle erfolgt zweckmäßigerweise mittels rasterelektronenmikroskopischer Aufnahmen (SEM) an einem polierten Querschnitt der zu untersuchenden Lage. Die Breite eines Kristalls ist definiert als der Abstand zweier benachbarter Korngrenzen entlang einer zur Substratoberfläche parallelen Linie, wobei diese Linie in einer Höhe verläuft, die 50% der Dicke der Lage entspricht, wenn nichts anderes angegeben ist. Zu Zwecken der vorliegenden Erfindung ist die Kristalllänge definiert als die maximale Ausdehnung der Kristalle in der Richtung senkrecht zur Substratoberfläche, obwohl die Wachstumsrichtung der Kristalle nicht immer perfekt senkrecht zur Substratoberfläche verläuft. Dies führt statistisch zu einer Unterbestimmung der gemessenen mittleren Kristalllänge gegenüber der tatsächlichen mittleren Kristalllänge.

In einer weiteren bevorzugten Ausführungsform der erfindungsgemäßen $Ti_{1-x}Al_xC_yN_z$-Lage mit Lamellen aus periodisch alternierenden Bereichen mit abwechselnd unterschiedlichen stöchiometrischen Anteilen an Ti und Al weisen die sich jeweils in Schichtwachstums-Richtung unterhalb und oberhalb eines Bereichs der Lamellen anschließenden Bereiche mit anderen Ti- und Al-Anteilen die gleiche kristallographische Orientierung auf. Bei einer solchen Abfolge hat die erfindungsgemäße Schicht eine gut ausgeprägte Kristallinität mit geringen Anteilen an Korngrenzen oder amporphen Schichtbestandteilen, was eine höhere Verschleißbeständigkeit zur Folge hat.

In einer weiteren bevorzugten Ausführungsform der Erfindung besitzt die $Ti_{1-x}Al_xC_yN_z$-Lage, wie oben ausgeführt, eine kolumnare Mikrostruktur, wobei die kolumnaren Kristallite eine mittlere Länge aufweisen, welche wenigstens das 0,35-fache, vorzugsweise wenigstens das 0,5-fache, besonders bevorzugt wenigstens das 0,7-fache der Dicke der $Ti_{1-x}Al_xC_yN_z$-Lage beträgt.

Eine zu niedrige mittlere Länge der Kristallite im Verhältnis zur Dicke der $Ti_{1-x}Al_xC_yN_z$-Lage hat eine zu geringe Beständigkeit gegen Freiflächenverschleiß zur Folge.

Es ist weiterhin bevorzugt, wenn die kolumnaren Kristallite ein Verhältnis der mittleren Länge zu der mittleren Breite, gemessen bei 50% der Dicke der $Ti_{1-x}Al_xC_yN_z$-Lage, von wenigstens 2,5, vorzugsweise wenigstens 5, besonders bevorzugt wenigstens 7 aufweisen.

Ist das Verhältnis der mittleren Länge zu der mittleren Breite der Kristallite niedriger, hat dies ebenfalls den Nachteil der geringeren Beständigkeit gegen Freiflächenverschleiß in der Zerspanung.

In einer weiteren bevorzugten Ausführungsform der Erfindung weist die $Ti_{1-x}Al_xC_yN_z$-Lage eine Vorzugsorientierung des Kristallwachstums bezüglich einer kristallografischen {hkl}-Ebene auf, gekennzeichnet durch einen Texturkoeffizienten TC (hkl) > 1,5, vorzugsweise > 2, besonders bevorzugt > 3, wobei der Texturkoeffizienten TC (hkl) wie folgt definiert ist:

$$TC(hkl) = \frac{I(hkl)}{I_0(hkl)} \left[ \frac{1}{n} \sum_{n-1}^{n} \frac{I(hkl)}{I_0(hkl)} \right]^{-1},$$

wobei

- I(hkl) die durch Röntgenbeugung gemessenen Intensitäten der Beugungsreflexe sind,
- $I_0$(hkl) die Standardintensitäten der Beugungsreflexe der reinen fcc-AlN-Phase nach pdf-Karte 00-046-1200 sind,
- n die Anzahl der für die Berechnung verwendeten Reflexe ist und
- für die Berechnung von TC(hkl) die Reflexe (111), (200), (220) und (311) verwendet werden, wobei die Vorzugsorientierung des Kristallwachstums der $Ti_{1-x}Al_xC_yN_z$-Lage bezüglich der kristallografischen {111}-, {200}-, {220}- oder {311}-Ebene, besonders bevorzugt bezüglich der kristallografischen {111}-Ebene vorliegt.

Eine Vorzugsorientierung des Kristallwachstums bezüglich einer kristallografischen {111}-Ebene hat sich insbesondere in der Drehbearbeitung von Gusswerkstoffen als vorteilhaft erwiesen.

In einer weiteren bevorzugten Ausführungsform der Erfindung weist die $Ti_{1-x}Al_xC_yN_z$-Lage eine Vorzugsorientierung des Kristallwachstums bezüglich einer kristallografischen {hkl}-Ebene auf, welche dadurch charakterisiert ist, dass das Maximum des Röntgenbeugungspeaks der kristallografischen {hkl}-Ebene, gemessen durch Röntgenbeugungsdiffraktometrie (XRD) und/oder Elektronen-Rückstreubeugung (EBSD), innerhalb eines Winkels $\alpha = \pm 20$ Grad, vorzugsweise innerhalb eines Winkels $\alpha = \pm 10$ Grad, besonders bevorzugt innerhalb eines Winkels $\alpha = \pm 5$ Grad, ganz besonders bevorzugt innerhalb eines Winkels $\alpha = \pm 1$ Grad zur Senkrechen auf die Oberfläche des Grundkörpers gemessen wird, wobei die Vorzugsorientierung des Kristallwachstums der $Ti_{1-x}Al_xC_yN_z$-Lage bezüglich der kristallografischen {111}-, {200}-, {220}- oder {311}-Ebene, besonders bevorzugt bezüglich der kristallografischen {111 }-Ebene vorliegt.

Maßgeblich hierbei ist der Schnitt durch die Polfigur der {hkl}-Ebene des fcc-$Ti_{1-x}Al_xC_yN_z$ nach Integration der Intensitäten über den Azimut-Winkel $\beta$ (Rotationswinkel um die Probenoberflächennormale).

In einer weiteren bevorzugten Ausführungsform der Erfindung beträgt die Halbwertsbreite (FWHM) wenigstens eines der Röntgenbeugungspeaks der kristallografischen {111}-, {200}-, {220}- und {311}-Ebenen < 1° $2\theta$, vorzugsweise < 0,6° $2\theta$, besonders bevorzugt < 0,45° $2\theta$, vorzugsweise die Halbwertsbreite (FWHM) des Röntgenbeugungspeaks der kristallografischen {111}-Ebene.

Eine zu hohe Halbwertsbreite (FWHM) des Röntgenbeugungspeaks der {111}-Ebene der $Ti_{1-x}Al_xC_yN_z$-Lage deutet auf geringere Korngrößen der kubisch flächenzentrierten (fcc) Phase oder gar auf Anteile amorpher Phasen hin. Dies hat sich in den bisherigen Tests als nachteilig für die Verschleißbeständigkeit erwiesen.

In einer weiteren bevorzugten Ausführungsform der Erfindung weist die $Ti_{1-x}Al_xC_yN_z$-Lage eine Vorzugsorientierung des Kristallwachstums bezüglich der kristallografischen {111}-Ebene auf, die durch ein Verhältnis der Intensitäten der Röntgenbeugungspeaks der kristallografischen {111}-Ebene und der {200}-Ebene, I{111} bzw. I{200}, charakterisiert ist, bei dem I{111} / I{200} > $1+h(\ln h)^2$, vorzugsweise I{111} / I{200} > $1+(h+3)x(\ln h)^2$ beträgt, wobei h die Dicke der $Ti_{1-x}Al_xC_yN_z$-Lage in "$\mu m$" ist.

Ein Verhältnis I{111} / I{200} > $1+h(\ln h)^2$ oder sogar > $1+(h+3)x(\ln h)^{2\,2}$ charakterisiert eine besonders stark ausgeprägte {111} kristallographische Vorzugsorientierung der Schicht, welche sich insbesondere in der Bearbeitung von Gusswerkstoffen als besonders vorteilhaft erwiesen hat.

In einer weiteren bevorzugten Ausführungsform der Erfindung weist die $Ti_{1-x}Al_xC_yN_z$-Lage Stöchiometriekoeffizienten $0,70 \leq x < 1$, $y = 0$ und $0,95 \leq z < 1,15$ auf, d. h. es handelt sich um eine reine TiAlN-Lage. Diese hat gegenüber einer TiAlCN-Lage den Vorteil, dass bei der satzweisen Beschichtung allgemein eine einfachere Prozessführung möglich ist und im Besonderen eine gleichmäßige Einstellung der Schichteigenschaften und der Schichtzusammensetzung innerhalb der Beschichtungscharge erleichtert wird. Zudem ist bei TiAlCN-Lagen davon auszugehen, dass sich nur begrenzte Mengen an Kohlenstoff im Gitter der kubischen Phase lösen und überschüssiger Kohlenstoff in amorpher Form vorliegen kann. Bei einer solchen Zusammensetzung können je nach Anwendungsgebiet die geringere Härte der Schicht oder günstige tribologische Eigenschaften ausschlaggebend für die Werkzeugstandzeit sein.

In einer weiteren bevorzugten Ausführungsform der Erfindung weist die $Ti_{1-x}Al_xC_yN_z$-Lage eine Vickers-Härte (HV) > 2300 HV, vorzugsweise > 2750 HV, besonders bevorzugt > 3000 HV aufweist.

Eine zu geringe Vickers-Härte hat den Nachteil der zu geringen Verschleißbeständigkeit. Erreicht wird die hohe Vickers-Härte der erfindungsgemäßen Lage durch die erfindungsgemäße Prozessführung, mit der kubische $Ti_{1-x}Al_xC_yN_z$-Lagen mit geringen, vorzugsweise keinen nachweisbaren Anteilen an weicheren Fremdphasen wie hexagonalem AlN erhalten werden.

In einer weiteren bevorzugten Ausführungsform der Erfindung ist zwischen dem Grundkörper und der $Ti_{1-x}Al_xC_yN_z$-Lage wenigstens eine weitere Hartstofflage mit einer Dicke von 0,05 $\mu m$ bis 7 $\mu m$, vorzugsweise von 0,1 $\mu m$ bis 5 $\mu m$, besonders bevorzugt von 0,2 $\mu m$ bis 3 $\mu m$, angeordnet, ausgewählt unter einer TiN-Lage, einer mittels Hochtemperatur-CVD (CVD) oder Mitteltemperatur-CVD (MT-CVD) abgeschiedenen TiCN-Lage, einer $Al_2O_3$-Lage und Kombinationen davon. Darüber hinaus ist es bevorzugt, wenn über der $Ti_{1-x}Al_xC_yN_z$-Lage wenigstens eine weitere Hartstofflage angeordnet ist, vorzugsweise wenigstens eine $Al_2O_3$-Lage der Modifikation $\gamma$-$Al_2O_3$, $\kappa$-$Al_2O_3$ oder $\alpha$-$Al_2O_3$, besonders bevorzugt eine $\alpha$-$Al_2O_3$-Lage, wobei die $Al_2O_3$-Lage mittels Hochtemperatur-CVD (CVD) oder Mitteltemperatur-CVD (MT-CVD) abgeschieden ist.

Die Erfindung umfasst auch ein Verfahren zur Herstellung hierin beschriebenen des erfindungsgemäßen Werkzeugs, wobei zur Herstellung der $Ti_{1-x}Al_xC_yN_z$-Lage mit lamellarer Struktur

a) der zu beschichtende Körper in einem im Wesentlichen zylindrischen CVD-Reaktor platziert werden, der für ein Anströmen der zu beschichtenden Körper mit den Prozessgasen in einer Richtung im Wesentlichen radial zur Längsachse des Reaktors ausgelegt ist,

b) zwei Vorläufergasgemische (VG1) und (VG2) bereitgestellt werden, wobei das erste Vorläufergasgemisch (VG1) 0,005% bis 0,2 Vol.-% $TiCl_4$, 0,025% bis 0,5 Vol.-% $AlCl_3$ und als Trägergas Wasserstoff ($H_2$) oder ein Gemisch aus Wasserstoff und Stickstoff ($H_2/N_2$) enthält und das zweite Vorläufergasgemisch (VG2) 0,1 bis 3,0 Vol.-% wenigstens eines N-Donors, ausgewählt unter Ammoniak ($NH_3$) und Hydrazin ($N_2H_4$), und als Trägergas Wasserstoff ($H_2$) oder ein Gemisch aus Wasserstoff und Stickstoff ($H_2/N_2$) enthält, und das erste Vorläufergasgemisch (VG1) und/oder das zweite Vorläufergasgemisch (VG2) gegebenenfalls einem C-Donor, ausgewählt unter Acetonitril ($CH_3CN$), Ethan ($C_2H_6$), Ethen ($C_2H_4$) und Ethin ($C_2H_2$) und Gemischen davon, enthält, wobei der Gesamt-Vol.-%-Anteil von N-Donor und C-Donor in den Vorläufergasgemischen (VG1, VG2) im Bereich von 0,1 bis 3,0 Vol.-% liegt,

c) die zwei Vorläufergasgemische (VG1, VG2) vor dem Eintritt in die Reaktionszone getrennt gehalten werden und bei einer Prozesstemperatur im CVD-Reaktor im Bereich von 600°C bis 850 °C und einem Prozessdruck im CVD-Reaktor im Bereich von 0,05 bis 18 kPa im Wesentlichen radial zur Längsachse des Reaktors eingeleitet werden, wobei die Volumengasströme ($\dot{V}$) der Vorläufergasgemische (VG1, VG2) so gewählt werden, dass die mittlere Verweilzeit ($\tau$) im CVD-Reaktor weniger als 1 Sekunde beträgt.

Eine wesentliche Verfahrensmaßnahme zum Erzielen der erfindungsgemäßen Struktur der $Ti_{1-x}Al_xC_yN_z$-Lage ist das Einstellen der Volumengasströme ($\dot{V}$) der Vorläufergasgemische (VG1, VG2), dass die mittlere Verweilzeit ($\tau$) im CVD-Reaktor weniger als 1 Sekunde beträgt. Bevorzugt werden die Volumengasströme ($\dot{V}$) der Vorläufergasgemische (VG1, VG2) so gewählt werden, dass die mittlere Verweilzeit ($\tau$) im CVD-Reaktor weniger als 0,5 Sekunden, besonder bevorzugt weniger als 0,35 Sekunden beträgt.

Ist die mittlere Verweilzeit Volumengasströme ($\dot{V}$) zu lang, wird die erfindungsgemäße lamellare Struktur nicht sicher erhalten und/oder die Schichten enthalten einen zu hohen Anteil an hexagonalem AlN.

Das erfindungsgemäße Verfahren wird vorzugsweise bei einer Prozesstemperatur im CVD-Reaktor im Bereich von 625°C bis 800 °C, vorzugsweise im Bereich von 650°C bis 725 °C und/oder bei einem Prozessdruck im CVD-Reaktor im Bereich von 0,05 bis 8 kPa, vorzugsweise im Bereich von 0,1 bis 7 kPa durchgeführt.

Ist die Prozesstemperatur im CVD-Reaktor zu hoch, werden hohe Gehalte an hexagonalem AlN in der Schicht erhalten, wodurch u.a. die Schichthärte sinkt. Ist die Prozesstemperatur im CVD-Reaktor hingegen zu niedrig, kann die Abscheiderate in einen unwirtschaftlichen Bereich sinken. Zudem werden bei niedrigen Temperaturen Schichten mit Chlor-Gehalten >1 At.-% und geringerer Härte erhalten.

Ist der Prozessdruck im CVD-Reaktor zu hoch, führt dies zu einer ungleichmäßigen Schichtdicken-Verteilung an den Werkzeugen mit erhöhter Schichtdicke an den Kanten, dem sogenannten Dogbone-Effekt. Zudem werden häufig hohe Anteile an hexagonalem AlN erhalten. Ein Prozessdruck im CVD-Reaktor kleiner 0,05 kPa ist hingegen technisch schwierig zu realisieren. Zudem ist bei zu niedrigem Prozessdruck die gleichmäßige Beschichtung der Werkzeuge nicht mehr gewährleistet

In einer weiteren bevorzugten Ausführungsform des erfindungsgemäßen Verfahrens beträgt das Verhältnis der Volumengasströme ($\dot{V}$) der Vorläufergasgemische (VG1, VG2) $\dot{V}$(VG1)/$\dot{V}$ (VG2) kleiner als 1,5, vorzugsweise kleiner als 1,25, besonders bevorzugt kleiner als 1,15.

Es wurde überraschend gefunden, dass durch ein niedriges Verhältnis der Volumengasströme ($\dot{V}$) kleiner als 1,5 oder sogar noch niedriger eine besonders ausgeprägte {111}-Vorzugsorientierung des Kristallwachstums erzielt werden kann. Ist das Verhältnis der der Volumengasströme der Vorläufergasgemische (VG1, VG2) zu hoch, wird in der Regel eine andere als die erfindungsgemäß besonders bevorzugte {111}-Vorzugsorientierung erhalten.

Im Sinne der vorliegenden Erfindung beziehen sich Vol.-%-Anteile in den Vorläufergasgemischen auf das Gesamtvolumen des in die Reaktionszone eingeleiteten Gasgemisches aus den ersten und zweiten Vorläufergasgemischen.

Es wurde überraschend gefunden, dass durch die erfindungsgemäße Prozessführung $Ti_{1-x}Al_xC_yN_z$- und $Ti_{1-x}Al_xN_z$-Lagen mit Stöchiometriekoeffizienten $0,70 \leq x < 1$, $0 \leq y < 0,25$ und $0,75 \leq z < 1,15$ und mit kubisch flächenzentriertem Gitter hergestellt werden können, die eine lamellare Struktur aus periodisch alternierenden Bereichen aufweisen, welche aus abwechselnd unterschiedlichen stöchiometrischen Anteilen an Ti und Al gebildet sind, welche die gleiche Kristallstruktur aufweisen. Die erfindungsgemäßen Beschichtungen weisen im Vergleich zu bekannten Beschichtungen mit TiAlCN- und TiAlN-Lagen, insbesondere solchen, welche aus abwechselnd kubisch flächenzentrierten und hexagonalen Kristallstrukturen der Lamellen bestehen, überragende Eigenschaften in der Metallbearbeitung auf. Es wurde weiterhin überraschenderweise gefunden, dass man bei einem Schneideinsatz mit einer Beschichtung der hierin beschriebenen Art bei der spanenden Metallbearbeitung, insbesondere bei der Dreh- und Fräsbearbeitung von Stahl- oder Gusswerkstoffen, eine gegenüber bekannten Schneideinsätzen verbesserte Verschleißbeständigkeit und einem breiteren Anwendungsbereich erzielen kann.

Bei dem erfindungsgemäßen CVD-Verfahren werden zwei Vorläufergasgemische (VG1) und (VG2) bereitgestellt, wobei das erste Vorläufergasgemisch (VG1) die Metalle Ti und Al in der Form ihrer Chloride und Trägergas enthält und das zweite Vorläufergasgemisch (VG2) wenigstens einen N-Donor enthält. Für die Herstellung einer reinen TiAlN-Lage wird in der Regel nur N-Donor Ammoniak ($NH_3$) oder Hydrazin ($N_2H_4$) eingesetzt. Für die Herstellung TiAlCN-Lage werden N-Donor und C-Donor eingesetzt, beispielsweise Ammoniak ($NH_3$) im Gemisch mit Ethen ($C_2H_4$). Acetonitril ($CH_3CN$) wirkt im erfindungsgemäßen Verfahren überwiegend als C-Donor und wird demzufolge im Gemisch mit einem N-Donor eingesetzt. Je nach gewünschter Stöchiometrie können Gemische mit weiteren N-Donoren und C-Donoren eingesetzt werden. Für das erfindungsgemäße Verfahren ist erforderlich, dass der N-Donor getrennt von den Chloriden der Metalle Ti und Al zugeführt wird, dagegen kann der C-Donor sowohl über das erste Vorläufergasgemisch (VG1) als auch über das zweite Vorläufergasgemisch (VG2) zugeführt werden. In einer weiteren bevorzugten Ausführungsform der Erfindung ist der N-Donor Ammoniak ($NH_3$).

Das erfindungsgemäß angewendete CVD-Verfahren ist ein MT-CVD-Verfahren bei einer Prozesstemperatur im CVD-Reaktor im Bereich von 600°C bis 850 °C und einem Prozessdruck im Bereich von 0,05 bis 8 kPa. Der CVD-Reaktor ist ein im Wesentlichen zylindrischer Reaktor, der für ein Anströmen der zu beschichtenden Körper mit den Prozessgasen in einer Richtung im Wesentlichen radial zur Längsachse des Reaktors ausgelegt ist, d. h. von der Mittelachse des zylindrischen Reaktors in Richtung der vom Zylindermantel gebildeten Außenwände des Reaktors. Solche zylindrischen Reaktoren sind bekannt und kommerziell erhältlich, beispielsweise die CVD-Beschichtungssysteme des Typs Bernex® BPXpro der Firma Ionbond AG Olten, Schweiz.

Eine wesentliche Verfahrensmaßnahme des erfindungsgemäßen Verfahrens besteht darin, dass die zwei Vorläufergasgemische (VG1) und (VG2) vor dem Eintritt in die Reaktionszone getrennt gehalten werden. Wird dies nicht eingehalten, können die Vorläufergasströme bereits zu früh reagieren, beispielsweise in den Zuführungsleitungen, und die gewünschte Beschichtung wird nicht erzielt.

**Beschreibung der Figuren**

Figur 1: zeigt eine Rasterelektronenmikroskopaufnahme (SEM) einer erfindungsgemäßen Lage.

Figur 2: zeigt eine weitere Rasterelektronenmikroskopaufnahme (SEM) der erfindungsgemäßen Lage gemäß Figur 1 in höherer Vergrößerung. In der Aufnahme mit einem InLEns-SE-Detektor ist erkennbar, dass sich die Lamellenstruktur im Wesentlichen über die gesamte Lage erstreckt.

Figur 3 zeigt STEM-Aufnahmen der erfindungsgemäßen Lage gemäß den Figuren 1 und 2. Figur 3A: Hellfeld-Aufnahme; Figur 3B: HAADF- (High Angle Annular Dark Field) Aufnahme. Die Kontrast-Inversion beim Wechsel zwischen den beiden Detektor-Signalen ist ein Anzeichen für Unterschiede in der chemischen Zusammensetzung zwischen den hellen und dunklen Bereichen der Lamellen.

Figur 4 zeigt eine hochauflösende HRTEM-Aufnahme der lamellaren Struktur der erfindungsgemäßen Lage gemäß den Figuren 1 und 2.

Figur 5 zeigt Fourier-Transformationen der gesamten Aufnahme der Figur 4 (Figur 5(A)) sowie von Ausschnitten aus der Figur 4 (Figuren 5(B), 5(C) und 5(D)).

**Definitionen und Methoden**

Mittlere Verweilzeit

Die mittlere Verweilzeit $\tau$ in der Reaktionszone des CVD-Reaktors im Sinne der vorliegenden Erfindung ist definiert als der Quotient aus Reaktorvolumen $V_R$ und austretendem Volumengasstrom $\dot{V}$ bei dem am Reaktorausgang gemessenen Prozessdruck $p$:

$$\tau = \frac{V_R}{\dot{V}} = \frac{V_R p}{\dot{V}_N p_N}$$

wobei $\dot{V}_N$ der Volumengasstrom unter Normbedingungen und $p_N$ $p_N$ der Normdruck = 101,325 Pa sind. Für die Berechnung der mittleren Verweilzeit gemäß der vorliegenden Anmeldung wird anstatt des gesamten Reaktorvolumens nur das Volumen des im Reaktor befindlichen Chargenaufbaus als Volumen $V_R$ verwendet.

Röntgendiffraktometrie (XRD)

Röntgenbeugungsmessungen wurden an einem Diffraktometer des Typs GE Sensing & Inspection Technologies PTS3003 unter Verwendung von CuK$\alpha$-Strahlung durchgeführt. Für $\theta$-2$\theta$-Eigenspannungs- und Polfigurmessungen wurde eine Parallelstrahloptik verwendet, die primärseitig aus einer Polykapillare und einem 2mm-Pinhole als Kollimator bestand. Sekundärseitig wurde ein Parallelplatten-Kollimator mit 0,4° Divergenz und ein Nickel K$_\beta$-Filter verwendet.
Peakintensitäten und -halbwertsbreiten wurden anhand von $\theta$-2$\theta$-Messungen bestimmt. Nach Abzug des Untergrundes wurden Pseudo-Voigt-Funktionen an die Messdaten gefittet, wobei der K$\alpha_2$-Abzug mittels K$\alpha_1$/K$\alpha_2$-Dublett-Anpassung erfolgte. Die in Tabelle 4 aufgeführten Werte der Intensitäten und Halbwertsbreiten beziehen sich auf die derart angefitteten K$\alpha_1$-Inteferenzen. Die Gitterkonstanten sind nach dem Vergardschen Gesetz unter Annahme der Gitterkonstanten von TiN und AlN aus den PDF-Karten 38-1420 bzw. 00-046-1200 berechnet.

Charakterisierung lamellarer Strukturen in Ti$_{1-x}$Al$_x$C$_y$N$_z$-Lagen

Der Nachweis und die Charakterisierung des Vorliegens lamellarer Strukturen in den erfindungsgemäßen Ti$_{1-x}$Al$_x$C$_y$N$_z$-Lagen mittels Röntgendiffraktion (XRD) und konventioneller sowie hochauflösender Transmissionselektronenmikroskopie (TEM und HR-TEM) erfolgte wie es bei J. Keckes et al., "Self-organized periodic soft-hard nanolamellae in polycrystalline TiAlN thin films", Thin Solid Films 545 (2013), Seiten 29-32, beschrieben ist. Es wurde ein Transmissionselektronenmikroskop FEI Titan 80-300 mit Feldemissions-Kathode bei einer Beschleunigungsspannung von 300 kV verwendet. Rastertransmissionselektronenmikroskop-Bilder wurden mit Hellfeld- (BF; Bright Field) und High Angle Annular Dark Field- (HAADF) Detektoren aufgenommen. Zur Probenpräparation für die Transmissionselektronenmikroskopie wurde ein kombiniertes FIB / SEM-System benutzt (FIB = Focussed Ion Beam), welches mit einer Flüssig-Gallium-Ionenquelle bzw. einer Feldemissionskathode als Elektronenquelle sowie einem System zur ionen- und elektronenunterstützten Abscheidung von Pt ausgerüstet war. Mit Hilfe dieses Systems wurden Querschliffe als Lamellen per In-Situ Lift-Out aus der Schicht heraus präpariert und auf ausreichende Elektronentransparenz gedünnt..

### Polfiguren

Polfiguren des {111}-Reflexes wurden bei $2\theta = 38{,}0°$ über einen Winkelbereich von $0°<\alpha<75°$ (Inkrement 5°) und $0°<\beta<360°$ (Inkrement 5°) bei kreisförmiger Anordnung der Messpunkte erstellt. Die Intensitätsverteilung aller gemessenen und rückgerechneten Polfiguren war annähernd rotationssymmetrisch, d.h. die untersuchten Schichten wiesen Fasertexturen auf. Zur Überprüfung der Vorzugsorientierung wurden zusätzlich zur {111}-Polfigur an den {200}- und {220}-Reflexen Polfiguren gemessen. Die Orientierungsdichte-Verteilungsfunktion (ODF) wurde mit der Software LaboTex3.0 der Firma LaboSoft, Polen, berechnet und die Vorzugsorientierung als inverse Polfigur dargestellt. Bei den erfindungsgemäßen Schichten befand sich das Intensitätsmaximum in der kristallographischen Richtung <hkl> entsprechend der eingestellten Vorzugsorientierung oder in $\leq 20°$ Winkelabweichung von <hkl>, wobei <hkl> gleich <111>, <200>, <220> oder <311>, bevorzugt in <111>, war.

### EDX-Messungen (Energiedispersive Röngenspektroskopie)

EDX-Messungen wurden an einem Rasterelektronenmikroskop Supra 40 VP der Firma Carl Zeiss bei 15 kV Beschleunigungsspannung mit einem EDX-Spektrometer Typ INCA x-act der Firma Oxford Instruments, UK, durchgeführt.

### Mikrohärte-Bestimmung

Die Messung der Mikrohärte erfolgte nach DIN EN ISO 14577-1 und -4 mit einem Universalhärteprüfer Fischerscope H100 der Firma Helmut Fischer GmbH, Sindelfingen, Deutschland, an einem Querschiff der beschichteten Körper.

### Beispiele

### Beispiel 1: Herstellung von beschichteten Hartmetall-Wendeschneidplatten

Als Substratkörper wurden in diesen Beispielen Hartmetall-Wendeschneidplatten der Geometrie SEHW1204AFN mit einer Zusammensetzung von 90,5 Gew.-% WC, 8 Gew.-% Co und 1,5 Gew.-% (NbC+TaC) und mit einer mischcarbidfreien Randzone verwendet.

Zur Beschichtung der Hartmetall-Wendeschneidplatten wurde eine CVD-Beschichtungsanlage des Typs Bernex BPX325S mit einer Reaktorhöhe von 1250 mm, einem Reaktordurchmesser von 325 mm und einem Volumen des Chargenaufbaus von 40 Litern eingesetzt. Der Gasfluss erfolgte radial zur Längsachse des Reaktors.

Zur Anbindung der erfindungsgemäßen $Ti_{1-x}Al_xC_yN_z$-Lagen sowie der Vergleichslagen wurde unmittelbar auf dem Hartmetall-Substrat zunächst eine etwa 0,3 µm dicke TiN-Lage mittels CVD unter den in Tabelle 1 angegebenen Abscheidebedingungen aufgebracht:

Tabelle 1: Reaktionsbedingungen bei der Herstellung der Anbindungslage

| Anbindungslage | Temp. [°C] | Druck [kPA] | Zeit [min] | Reaktivgasgemisch [Vol.-%] | | |
|---|---|---|---|---|---|---|
| | | | | $TiCl_4$ | $N_2$ | $H_2$ |
| TiN | 850 | 15 | 90 | 1,0 | 44,0 | 55,0 |

Zur Herstellung der erfindungsgemäßen $Ti_{1-x}Al_xC_yN_z$-Lagen wurden ein erstes Vorläufergasgemisch (VG1) mit den Ausgangsverbindungen $TiCl_4$ und $AlCl_3$ und ein zweites Vorläufergasgemisch (VG2) mit der Ausgangsverbindung $NH_3$ als reaktive Stickstoffverbindung voneinander getrennt in den Reaktor eingeleitet, so dass eine Vermischung der beiden Gasströme erst bei Eintritt in die Reaktionszone erfolgte. Die Volumengasströme der Vorläufergasgemische (VG1) und (VG2) wurden so eingestellt, dass eine mittlere Verweilzeit $\tau$ des Reaktionsgases im Reaktor und ein Gesamtvolumenstrom unter Normbedingungen $\dot{V}_N$ erreicht wurde. Die Parameter bei der Herstellung der erfindungsgemäßen $Ti_{1-x}Al_xC_yN_z$-Beschichtung 1) sowie der Vergleichsbeschichtung 2) sind in Tabelle 2 wiedergegeben.

Tabelle 2: Reaktionsbedingungen bei der Herstellung von $Ti_{1-x}Al_xC_yN_z$-Beschichtungen

| #/ Lage | Temp. [°C] | Druck [kPA] | Zeit [min] | Gesamtvolumenstrom $V_N$ [l$_N$/min] | $\tau$ [sek] | Vorläufergasgemisch (VG1) | | | Vorläufergasgemisch (VG2) | |
|---|---|---|---|---|---|---|---|---|---|---|
| | | | | | | TiCl$_4$ | AlCl$_3$ | H$_2$ | H$_2$ | NH$_3$ |
| 1) TiAlN (Erf.) | 670 | 1,2 | 260 | 107 | 0,27 | 0,03 | 0,23 | 52,5 | 46,9 | 0,35 |
| 2) TiAlN (Vgl.) | 670 | 1,2 | 260 | 25 | 1,14 | 0,03 | 0,23 | 52,5 | 46,9 | 0,35 |

Zur Charakterisierung der erfindungsgemäßen $Ti_{1-x}Al_xC_yN_z$-Lagen wurden Röntgenbeugung (XRD), Elektronenbeugung, insbesondere EBSD, Rasterelektronenmikroskopie (SEM), Rastertransmissionselektronenmikroskopie (STEM) und Transmissionselektronenmikroskopie (TEM) sowie Mikrohärtemessung angewendet.

Die Lagendicke der erfindungsgemäßen $Ti_{1-x}Al_xC_yN_z$-Lage 1) betrug 4,5 $\mu$m, und die Lagendicke der Vergleichslage 2) betrug 6,25 $\mu$m. Die Mikrohärte der erfindungsgemäßen Lage 1) betrug 3070 $HV_{0,05}$, die Mikrohärte der Vergleichsbeschichtung 2) wurde mit 2300 $HV_{0,05}$ gemessen.

Die XRD-Analyse zeigte, dass die erfindungsgemäße Lage 1) im Wesentlichen aus reiner kubisch flächenzentrierter (fcc) Phase bestand und eine starke {111}-Vorzugsorientierung des Kristallwachstums aufwies. Die Halbwertsbreite des {111}-Reflexes betrug 0,64° 2$\theta$, und die Zusammensetzung der Schicht konnte mit etwa $Ti_{0,195}Al_{0,805}N_{1,05}$ bestimmt werden.

Die Vergleichsbeschichtung 2) zeigte in der XRD-Analyse breite Signale im Bereich von 30° $\leq 2\theta \leq$ 40°, welche von der eingesetzten Software als zwei Peaks (2$\theta$ = 36,98°, FWHM = 1,28° und 2$\theta$ = 37,83°, FWHM = 0,94°) angefittet wurden. Die hohe Peakbreite deutet auf eine feinkristalline Struktur hin. Die Zusammensetzung der Schicht betrug etwa $Ti_{0,3}Al_{0,7}N_{1,0}$. Zu welchen Anteilen das XRD-Signal auf die {101}-Interferenz von hexagonalem AlN und auf den {111}-Reflex von kubischem $Ti_{1-x}Al_xN_z$ zurückzuführen war, konnte anhand des Diffraktogramms nicht eindeutig bestimmt werden. Es ist jedoch davon auszugehen, dass signifikante Anteile von hexagonalem AlN in der Schicht vorliegen. Da im Winkelbereich 30° $\leq 2\theta \leq$ 40° die Schichtinterferenzen mit der höchsten Intensität vorliegen, kann auf eine {111} Vorzugsorientierung des kubischen Anteils der $Ti_{1-x}Al_xN_z$-Lage geschlossen werden.

Die {101}- bzw. {202}-Interferenzen von hexagonalem AlN und der {111}- bzw. {222}-Reflex von kubischem $Ti_{1-x}Al_xC_yN_z$ können sich je nach chemischer Zusammensetzung mehr oder weniger stark überlagern. Lediglich die Interferenz der {200}-Ebene des kubischen $Ti_{1-x}Al_xC_yN_z$ wird durch keine weiteren Interferenzen, wie z. B. durch den Substratkörper oder darüber oder darunter angeordnete Lagen, überlagert und besitzt für regellose Orientierung die höchste Intensität.

Zur Beurteilung des Volumenanteils an hexagonalem AlN im Messvolumen und zur Vermeidung von Fehlinterpretationen bezüglich der {111}- und {200}-Intensitäten des kubischen $Ti_{1-x}Al_xC_yN_z$, wurden daher Messungen ($\theta$-2$\theta$-Scans) unter zwei verschiedenen Kippwinkeln $\psi$ ($\psi$ = 0° und $\psi$ = 54,74°) durchgeführt. Da der Winkel zwischen den Ebenennormalen von {111} und {200} etwa 54,74° beträgt, ergibt sich bei einer starken {111}-Fasertextur ein Intensitätsmaximum des {200}-Reflexes bei dem Kippwinkel $\psi$ = 54,74°, während die Intensität des {111}-Reflexes gegen Null geht. Umgekehrt erhält man bei dem Kippwinkel $\psi$ = 54,74° ein starkes Intensitätsmaximum des {111}-Reflexes bei einer starken {200}-Fasertextur, während die Intensität des {200}-Reflexes gegen Null geht.

Für die hergestellten $Ti_{1-x}Al_xC_yN_z$-Lagen wurde auf diese Weise überprüft, ob die gemessene Intensität bei 2$\theta$ $\approx$ 38,1° vornehmlich der kubisch flächenzentrierten $Ti_{1-x}Al_xC_yN_z$-Phase zuzuordnen ist oder ob größere Anteile von hexagonalem AlN in der Schicht enthalten sind. Sowohl Röntgenbeugungsmessungen als auch EBSD-Messungen zeigten übereinstimmend nur sehr geringe Anteile hexagonaler AlN-Phase in den erfindungsgemäßen Lagen. Die chemische Zusammensetzung der erfindungsgemäßen $Ti_{1-x}Al_xN$-Lage 1) war etwa $Ti_{0,19}Al_{0,81}N$, was anhand der Position des {111}-Peaks nach dem Vegardschen Gesetz und unter Verwendung der entsprechenden {111}-Peakpositionen für reines fcc-TiN gemäß PDF-Karte 38-1420 und reinem fcc-AlN gemäß PDF-Karte 46-1200 als Referenzwerte berechnet wurde.

Querschnitte der erfindungsgemäßen $Ti_{1-x}Al_xC_yN_z$-Lagen wurden mittels Rasterelektronenmikroskopie (SEM), Rastertransmissionselektronenmikroskopie (STEM) und Transmissionselektronenmikroskopie (TEM) untersucht. Die erfindungsgemäße Lage 1) bestand aus kolumnaren Kristalliten mit einer typischen Länge nahe der Lagendicke von etwa 3-4 $\mu$m und einer mittleren Breite, gemessen bei 50% der Dicke der $Ti_{1-x}Al_xC_yN_z$-Lage, von etwa 200 nm. Das Länge-zu-Breite-Verhältnis betrug somit etwa 17,5. Rasterelektronenmikroskopische Aufnahmen (SEM) eines Querschliffs der Vergleichslage 2) zeigten eine feine Struktur, in der keine diskreten Kristallite erkennbar waren. In der Schicht war keine Lamellenstruktur erkennbar.

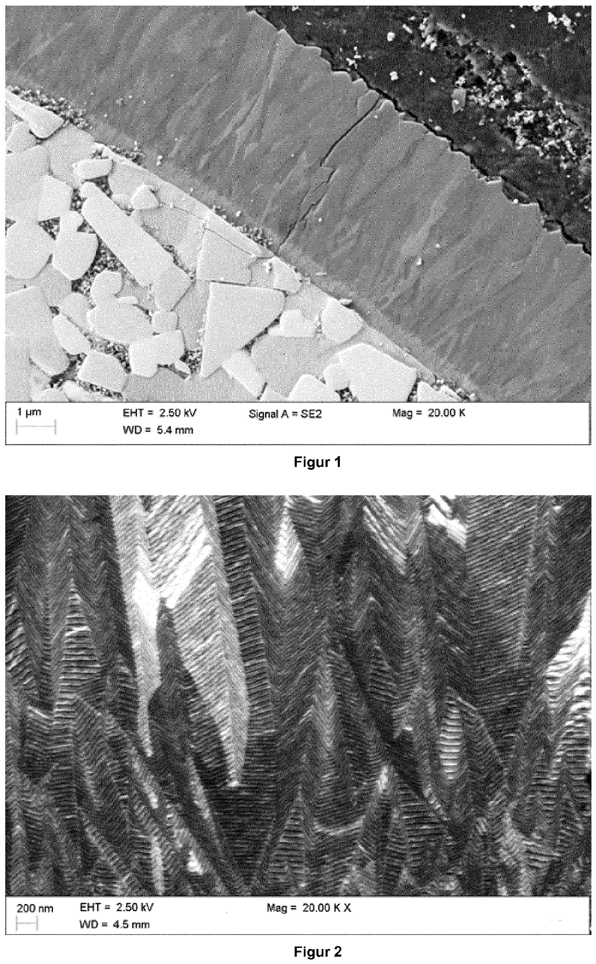

Die Figuren 1 und 2 zeigen Rasterelektronenmikroskopaufnahmen (SEM) der erfindungsgemäßen Lage 1).

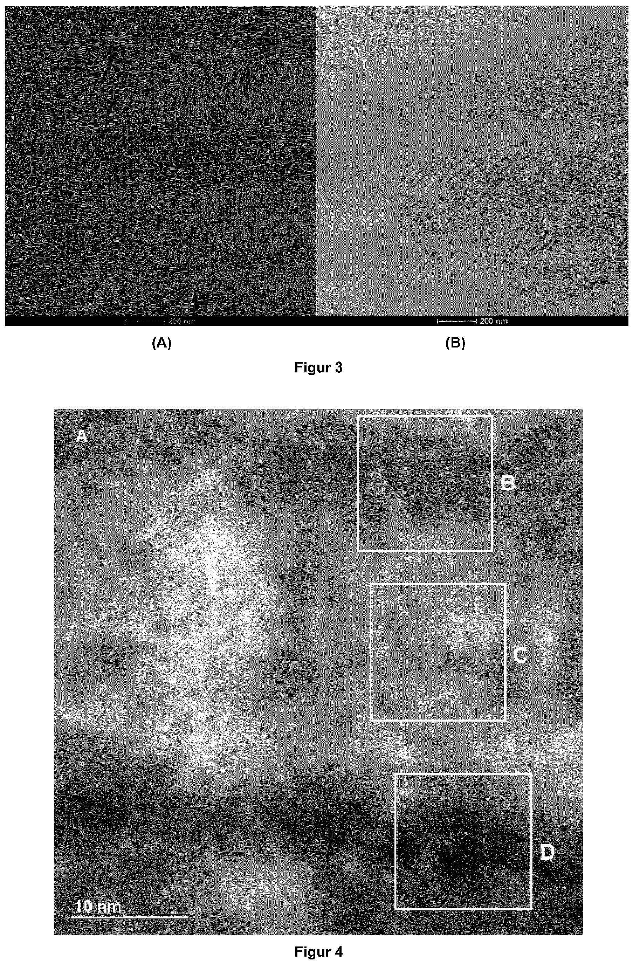

Figur 3 zeigt STEM-Aufnahmen der erfindungsgemäßen Lage 1) im Hellfeldmodus (BF) (Figur 3A) und im " high angle annular dark field" (HAADF) Dunkelfeldmodus (Figur 3B). Deutlich ist die erfindungsgemäße lamellare Struktur in allen Kristalliten zu erkennen, wobei die Schärfe des Kontrasts von der Ausrichtung des Kristalliten relativ zu dem Elektronenstrahl abhängt. Die Dicke der Lamellen beträgt etwa 30nm. Die Aufnahmen der Figur 3 wurden etwa in der Mitte der Lage aufgenommen, jedoch wurden die kolumnaren Kristallite mit lamellarer Struktur in der gesamten Lage beobachtet. Die Richtung des Lagenwachstums verläuft in den Aufnahmen der Figur 3 von links nach rechts. In den Kristalliten, welche den höchsten Kontrast zeigen, sind Bereiche unterschiedlicher Dicken innerhalb der Lamellenstruktur zu erkennen. Durch EDS-Analyse konnte gezeigt werden, dass die schmaleren Bereiche der Lamellen, die im BF dunkel und im HAADF hell erscheinen, höhere Ti-Anteile und niedrigere Al-Anteile haben als die breiteren Bereiche. Der Stickstoffanteil war in den verschiedenen Bereichen jedoch innerhalb der Messgenauigkeit gleich hoch. Die mittels EDS bestimmte Gesamtzusammensetzung stimmte mit der durch XRD bestimmten Gesamtzusammensetzung überein.

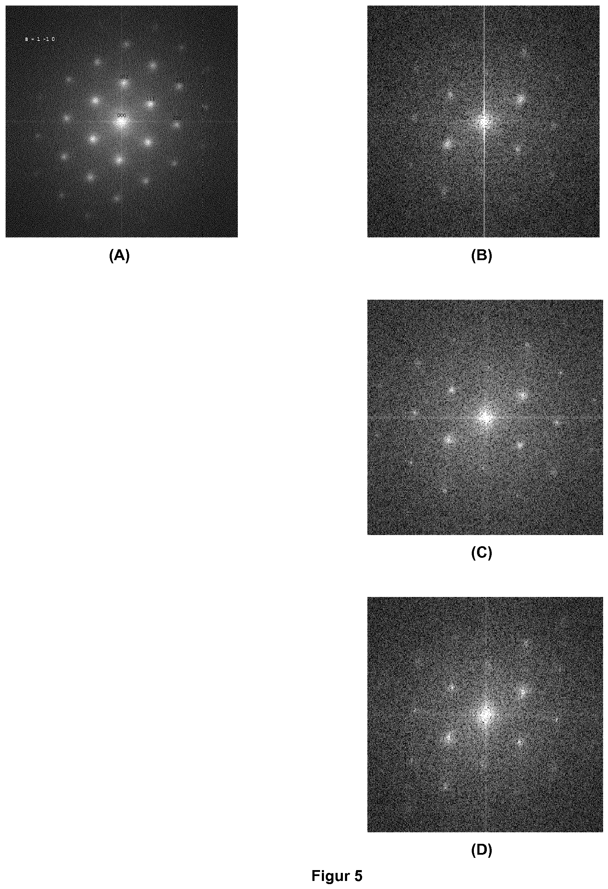

Figur 4 zeigt eine hochauflösende HRTEM-Aufnahme der lamellaren Struktur der erfindungsgemäßen Lage 1). Es sind zwei Lamellenbereiche zu erkennen, wobei die schmaleren Bereiche mit höherem Ti-Gehalt als dunkle Banden im oberen und unteren Bereich der Figur 4 zu erkennen sind. Von den drei in Figur 4 durch quadratische Rahmen markierten Bereichen (B, C, D) der Aufnahme gemäß Figur 4 wurden Fourier-Transformationen durchgeführt. Diese sind in Figur 5 als Figuren 5(B), 5(C) und 5(D) wiedergegeben. Die Rahmen B und D in Figur 4 (entsprechend Figuren 5(B) und 5(D)) decken die schmaleren, Ti-reicheren Bereiche ab, wogegen der Rahmen C in Figur 4 (entsprechend Figur 5(C)) einen breiteren, Al-reicheren Bereich abdeckt. Figur 5(A) zeigt die Fourier-Transformation der gesamten Figur 4.

Die Fourier-Transformationen der Figur 5 zeigen, dass die gesamte Struktur aus kubisch flächenzentrierter (fcc) Phase besteht. Innerhalb der Genauigkeit der Methode stimmt die anhand der Muster der Fourier-Transformationen bestimmte Gitterkonstante von 4.04 Å mit der durch XRD bestimmten Gitterkonstante von 4.08 Å überein. Darüber hinaus zeigen die Figuren 5(B), 5(C) und 5(D), dass in den drei verschiedenen von diesen Figuren abgedeckten Bereichen der lamellaren Struktur die gleiche Kristallstruktur (fcc) und die gleiche Orientierung vorliegt.

**Beispiel 2: Zerspanversuche**

Die gemäß Beispiel 1 hergestellten Hartmetall-Wendeschneidplatten mit der erfindungsgemäßen TiAlN-Lage 1) bzw. der Vergleichslage 2) sowie eine Hartmetall-Wendeschneidplatte einer kommerziell erhältlichen Sorte eines Wettbewerbers wurden zum Fräsen von Gusswerkstoffen eingesetzt. Das Wettbewerberwerkzeug wies eine Mehrlagenbeschichtung der Lagenabfolge TiN (0,5 $\mu$m) - TiCN (2 $\mu$m) - TiAlN (3 $\mu$m) auf, wobei die TiAlN-Lage nach XRD-Analyse eindeutig aus einem Phasengemisch von hexagonalem AlN und kubischem $Ti_{1-x}Al_xN_z$ bestand. In SEM-Aufnahmen war eine zweiphasige Struktur mit teilweiser Ausbildung von Lamellen erkennbar, ähnlich der in der WO 2013/134796 beschriebenen Struktur.

Mit den Schneideinsätzen wurden Fräsoperationen unter folgenden Schnittbedingungen durchgefü hrt:

Werkstückmaterial: Grauguss GG25

Gleichlauf, Trockenbearbeitung

| | |
|---|---|
| Zahnvorschub: | $f_z$ = 0,2 mm |
| Schnitttiefe: | $a_p$ = 3 mm |
| Schnittgeschwindigkeit: | $v_c$ = 283 m/min |
| Einstellwinkel: | $\kappa$ = 45° |
| Arbeitseingriff: | $a_e$ = 98 mm |
| Überstand: | $u_e$ = 5 mm |

Anschließend wurde die maximale Verschleissmarkenbreite $v_{B,max}$ an der Hauptschneide nach 4000 m Fräsweg bestimmt:

| Werkzeug | Verschleissmarkenbreite $v_{B,max}$ [mm] | Anzahl Kammrisse |
|---|---|---|
| 1) (Erfindung) | 0,20 | 1 |
| 2) (Vergleichsbeispiel) | 0,39 | 6 |
| Vergleichswerkzeug (Wettbewerb) | 0,35 | 4 |

**Patentansprüche**

1. Werkzeug mit einem Grundkörper aus Hartmetall, Cermet, Keramik, Stahl oder Schnellarbeitsstahl und einer darauf im CVD-Verfahren aufgebrachten ein- oder mehrlagigen Verschleißschutzbeschichtung mit einer Dicke im Bereich von 3 $\mu$m bis 25 $\mu$m, wobei die Verschleißschutzbeschichtung wenigstens eine $Ti_{1-x}Al_xC_yN_z$-Lage mit Stöchiometriekoeffizienten $0,70 \leq x < 1$, $0 \leq y < 0,25$ und $0,75 \leq z < 1,15$ und mit einer Dicke im Bereich von 1,5 $\mu$m bis 17 $\mu$m aufweist, **dadurch gekennzeichnet, dass**

   - die $Ti_{1-x}Al_xC_yN_z$-Lage eine lamellare Struktur besitzt mit Lamellen mit einer Dicke von nicht mehr als 150 nm, vorzugsweise nicht mehr als 100 nm, besonders bevorzugt nicht mehr als 50 nm, wobei

- die Lamellen aus periodisch alternierenden Bereichen der $Ti_{1-x}Al_xC_yN_z$-Lage mit abwechselnd unterschiedlichen stöchiometrischen Anteilen an Ti und Al gebildet sind, welche die gleiche Kristallstruktur (kristallographische Phase) aufweisen, und
- die $Ti_{1-x}Al_xC_yN_z$-Lage wenigstens 90 Vol.-% kubisch flächenzentrierte (fcc) Kristallstruktur aufweist.

**2.** Werkzeug nach Anspruch 1, **dadurch gekennzeichnet, dass** die $Ti_{1-x}Al_xC_yN_z$-Lage wenigstens 95 Vol.-%, vorzugsweise wenigstens 98 Vol.-%, besonders bevorzugt etwa 100 Vol.-% kubisch flächenzentrierte (fcc) Kristallstruktur aufweist.

**3.** Werkzeug nach einem der vorausgehenden Ansprüche, **dadurch gekennzeichnet, dass** in der $Ti_{1-x}Al_xC_yN_z$-Lage mit Lamellen aus periodisch alternierenden Bereichen mit abwechselnd unterschiedlichen stöchiometrischen Anteilen an Ti und Al sich jeweils in Schichtwachstums-Richtung unterhalb und oberhalb eines Bereichs der Lamellen anschließende Bereiche mit anderen Ti- und Al-Anteilen die gleiche kristallographische Orientierung aufweisen.

**4.** Werkzeug nach einem der vorausgehenden Ansprüche, **dadurch gekennzeichnet, dass** die $Ti_{1-x}Al_xC_yN_z$-Lage eine kolumnare Mikrostruktur besitzt, wobei die kolumnaren Kristallite eine mittlere Länge aufweisen, welche wenigstens das 0,35-fache, vorzugsweise wenigstens das 0,5-fache, besonders bevorzugt wenigstens das 0,7-fache der Dicke der $Ti_{1-x}Al_xC_yN_z$-Lage beträgt, und/oder
wobei die kolumnaren Kristallite ein Verhältnis der mittleren Länge zu der mittleren Breite, gemessen bei 50% der Dicke der $Ti_{1-x}Al_xC_yN_z$-Lage, von wenigstens 2,5, vorzugsweise wenigstens 5, besonders bevorzugt wenigstens 7 aufweisen.

**5.** Werkzeug nach einem der vorausgehenden Ansprüche, **dadurch gekennzeichnet, dass** die $Ti_{1-x}Al_xC_yN_z$-Lage eine Vorzugsorientierung des Kristallwachstums bezüglich einer kristallografischen {hkl}-Ebene aufweist, **gekennzeichnet durch** einen Texturkoeffizienten TC (hkl) > 1,5, vorzugsweise > 2, besonders bevorzugt > 3, wobei der Texturkoeffizienten TC (hkl) wie folgt definiert ist:

$$TC(hkl) = \frac{I(hkl)}{I_0(hkl)} \left[ \frac{1}{n} \sum_{n-1}^{n} \frac{I(hkl)}{I_0(hkl)} \right]^{-1},$$

wobei

- I(hkl) die durch Röntgenbeugung gemessenen Intensitäten der Beugungsreflexe sind,
- $I_0$(hkl) die Standardintensitäten der Beugungsreflexe nach pdf-Karte 00-046-1200 sind,
- n die Anzahl der für die Berechnung verwendeten Reflexe ist und
- für die Berechnung von TC(hkl) die Reflexe (111), (200), (220) und (311) verwendet werden,

wobei die Vorzugsorientierung des Kristallwachstums der $Ti_{1-x}Al_xC_yN_z$-Lage bezüglich der kristallografischen {111}-, {200}-, {220}- oder {311}-Ebene, besonders bevorzugt bezüglich der kristallografischen {111}-Ebene vorliegt.

**6.** Werkzeug nach einem der vorausgehenden Ansprüche, **dadurch gekennzeichnet, dass** die $Ti_{1-x}Al_xC_yN_z$-Lage eine Vorzugsorientierung des Kristallwachstums bezüglich einer kristallografischen {hkl}-Ebene aufweist, welche dadurch charakterisiert ist, dass das Maximum des Röntgenbeugungspeaks der kristallografischen {hkl}-Ebene, gemessen durch Röntgenbeugungsdiffraktometrie (XRD) und/oder Elektronen-Rückstreubeugung (EBSD), innerhalb eines Winkels $\alpha = \pm 20$ Grad, vorzugsweise innerhalb eines Winkels $\alpha = \pm 10$ Grad, besonders bevorzugt innerhalb eines Winkels $\alpha = \pm 5$ Grad, ganz besonders bevorzugt innerhalb eines Winkels $\alpha = \pm 1$ Grad zur Senkrechten auf die Oberfläche des Grundkörpers gemessen wird, wobei die Vorzugsorientierung des Kristallwachstums der $Ti_{1-x}Al_xC_yN_z$-Lage bezüglich der kristallografischen {111}-, {200}-, {220}- oder {311}-Ebene, besonders bevorzugt bezüglich der kristallografischen {111}-Ebene vorliegt.

**7.** Werkzeug nach einem der vorausgehenden Ansprüche, **dadurch gekennzeichnet, dass** die Halbwertsbreite (FWHM) wenigstens eines der Röntgenbeugungspeaks der kristallografischen {111}-, {200}-, {220}- und {311}-Ebenen < 1° 2θ, vorzugsweise < 0,6° 2θ, besonders bevorzugt < 0,45° 2θ beträgt, vorzugsweise die Halbwertsbreite (FWHM) des Röntgenbeugungspeaks der kristallografischen {111}-Ebene.

**8.** Werkzeug nach einem der vorausgehenden Ansprüche, **dadurch gekennzeichnet, dass** die $Ti_{1-x}Al_xC_yN_z$-Lage

eine Vorzugsorientierung des Kristallwachstums bezüglich der kristallografischen {111}-Ebene aufweist, die durch ein Verhältnis der Intensitäten der Röntgenbeugungspeaks der kristallografischen {111}-Ebene und der {200}-Ebene, I{111} bzw. I{200}, charakterisiert ist, bei dem I{111} / I{200} > 1+h (ln h)$^2$, vorzugsweise I{111} / I{200} > 1+(h+3)x(ln h)$^2$ beträgt, wobei h die Dicke der $Ti_{1-x}Al_xC_yN_z$-Lage in "$\mu$m" ist.

9. Werkzeug nach einem der vorausgehenden Ansprüche, **dadurch gekennzeichnet, dass** die $Ti_{1-x}Al_xC_yN_z$-Lage Stöchiometriekoeffizienten $0,70 \leq x < 1$, $y = 0$ und $0,95 \leq z < 1,15$ aufweist.

10. Werkzeug nach einem der vorausgehenden Ansprüche, **dadurch gekennzeichnet, dass** die $Ti_{1-x}Al_xC_yN_z$-Lage eine Vickers-Härte (HV) > 2300 HV, vorzugsweise > 2750 HV, besonders bevorzugt > 3000 HV aufweist.

11. Werkzeug nach einem der vorausgehenden Ansprüche, **dadurch gekennzeichnet, dass** zwischen dem Grundkörper und der $Ti_{1-x}Al_xC_yN_z$-Lage wenigstens eine weitere Hartstofflage mit einer Dicke von 0,05 $\mu$m bis 7 $\mu$m, vorzugsweise von 0,1 $\mu$m bis 5 $\mu$m, besonders bevorzugt von 0,2 $\mu$m bis 3 $\mu$m, angeordnet ist, ausgewählt unter einer TiN-Lage, einer mittels Hochtemperatur-CVD (CVD) oder Mitteltemperatur-CVD (MT-CVD) abgeschiedenen TiCN-Lage, einer $Al_2O_3$-Lage und Kombinationen davon und/oder über der $Ti_{1-x}Al_xC_yN_z$-Lage wenigstens eine weitere Hartstofflage angeordnet ist, vorzugsweise wenigstens eine $Al_2O_3$-Lage der Modifikation $\gamma$-$Al_2O_3$, $\kappa$-$Al_2O_3$ oder $\alpha$-$Al_2O_3$, besonders bevorzugt eine $\alpha$-$Al_2O_3$-Lage, wobei die $Al_2O_3$-Lage mittels Hochtemperatur-CVD (CVD) oder Mitteltemperatur-CVD (MT-CVD) abgeschieden ist.

12. Verfahren zur Herstellung eines Werkzeugs nach einem der vorausgehenden Ansprüche, wobei zur Herstellung der $Ti_{1-x}Al_xC_yN_z$-Lage mit lamellarer Struktur

a) die zu beschichtenden Körper in einem im Wesentlichen zylindrischen CVD-Reaktor platziert werden, der für ein Anströmen der zu beschichtenden Körper mit den Prozessgasen in einer Richtung im Wesentlichen radial zur Längsachse des Reaktors ausgelegt ist,
b) zwei Vorläufergasgemische (VG1) und (VG2) bereitgestellt werden, wobei das erste Vorläufergasgemisch (VG1) 0,005% bis 0,2 Vol.-% $TiCl_4$, 0,025% bis 0,5 Vol.-% $AlCl_3$ und als Trägergas Wasserstoff ($H_2$) oder ein Gemisch aus Wasserstoff und Stickstoff ($H_2/N_2$) enthält und das zweite Vorläufergasgemisch (VG2) 0,1 bis 3,0 Vol.-% wenigstens eines N-Donors, ausgewählt unter Ammoniak ($NH_3$) und Hydrazin ($N_2H_4$), und als Trägergas Wasserstoff ($H_2$) oder ein Gemisch aus Wasserstoff und Stickstoff ($H_2/N_2$) enthält, und das erste Vorläufergasgemisch (VG1) und/oder das zweite Vorläufergasgemisch (VG2) gegebenenfalls einem C-Donor, ausgewählt unter Acetonitril ($CH_3CN$), Ethan ($C_2H_6$), Ethen ($C_2H_4$) und Ethin ($C_2H_2$) und Gemischen davon, enthält, wobei der Gesamt-Vol.-%-Anteil von N-Donor und C-Donor in den Vorläufergasgemischen (VG1, VG2) im Bereich von 0,1 bis 3,0 Vol.-% liegt,
c) die zwei Vorläufergasgemische (VG1, VG2) vor dem Eintritt in die Reaktionszone getrennt gehalten werden und bei einer Prozesstemperatur im CVD-Reaktor im Bereich von 600°C bis 850 °C und einem Prozessdruck im CVD-Reaktor im Bereich von 0,05 bis 18 kPa im Wesentlichen radial zur Längsachse des Reaktors eingeleitet werden,

wobei die Volumengasströme ($\dot{V}$) der Vorläufergasgemische (VG1, VG2) so gewählt werden, dass die mittlere Verweilzeit ($\tau$) im CVD-Reaktor weniger als 1 Sekunde beträgt.

13. Verfahren nach Anspruch 12, **dadurch gekennzeichnet, dass** die Volumengasströme ($\dot{V}$) der Vorläufergasgemische (VG1, VG2) so gewählt werden, dass die mittlere Verweilzeit ($\tau$) im CVD-Reaktor weniger als 0,5 Sekunden, vorzugsweise weniger als 0,35 Sekunden beträgt.

14. Verfahren nach einem der Ansprüche 12 oder 13, **dadurch gekennzeichnet, dass** die Prozesstemperatur im CVD-Reaktor im Bereich von 625°C bis 800 °C, vorzugsweise im Bereich von 650°C bis 725 °C liegt und/oder der Prozessdruck im CVD-Reaktor im Bereich von 0,05 bis 8 kPa, vorzugsweise im Bereich von 0,1 bis 7 kPa liegt.

15. Verfahren nach einem der Ansprüche 12 bis 14, **dadurch gekennzeichnet, dass** das Verhältnis der Volumengasströme ($\dot{V}$) der Vorläufergasgemische (VG1, VG2) $\dot{V}$(VG1)/$\dot{V}$(VG2) kleiner als 1,5, vorzugsweise kleiner als 1,25, besonders bevorzugt kleiner als 1,15 beträgt.

**Claims**

1. A tool having a base body of cemented carbide, cermet, ceramic, steel or high speed steel and a single-layer or multi-layer wear-protection coating applied thereto in a CVD process and of a thickness in the range of 3 $\mu$m to 25 $\mu$m, wherein the wear-protection coating has at least one $Ti_{1-x}Al_xC_yN_z$ layer having stoichiometry coefficients 0.70 $\leq$ x < 1, 0 $\leq$ y < 0.25 and 0.75 $\leq$ z < 1.15, and with a thickness in the range of 1.5 $\mu$m to 17 $\mu$m, **characterised in that**

   - the $Ti_{1-x}Al_xC_yN_z$ layer has a lamellar structure with lamellae of a thickness of not more than 150 nm, preferably not more than 100 nm, particularly preferably not more than 50 nm, wherein
   - the lamellae are formed from periodically alternating regions of the $Ti_{1-x}Al_xC_yN_z$ layer with alternately different stoichiometric proportions of Ti and Al, having the same crystal structure (crystallographic phase), and
   - the $Ti_{1-x}Al_xC_yN_z$ layer has at least 90 vol-% of face-centred cubic (fcc) crystal structure.

2. A tool according to claim 1 **characterised in that** the $Ti_{1-x}Al_xC_yN_z$ layer has at least 95 vol-%, preferably at least 98 vol-%, particularly preferably about 100 vol-% of face-centred cubic (fcc) crystal structure.

3. A tool according to one of the preceding claims **characterised in that** in the $Ti_{1-x}Al_xC_yN_z$ layer with lamellae comprising periodically alternating regions with alternately different stoichiometric proportions of Ti and Al regions with other Ti and Al proportions which respectively adjoin below and above a region of the lamellae in the layer growth direction have the same crystallographic orientation.

4. A tool according to one of the preceding claims **characterised in that** the $Ti_{1-x}Al_xC_yN_z$ layer has a columnar microstructure, wherein the columnar crystallites have a mean length which is at least 0.35 times, preferably at least 0.5 times, particularly preferably at least 0.7 times the thickness of the $Ti_{1-x}Al_xC_yN_z$ layer, and/or wherein the columnar crystallites have a ratio of the mean length to the mean width, measured at 50% of the thickness of the $Ti_{1-x}Al_xC_yN_z$ layer, of at least 2.5, preferably at least 5, particularly preferably at least 7.

5. A tool according to one of the preceding claims **characterised in that** the $Ti_{1-x}Al_xC_yN_z$ layer has a preferential orientation of crystal growth with respect to a crystallographic {hkl} plane, **characterised by** a texture coefficient TC (hkl) > 1.5, preferably > 2, particularly preferably > 3, wherein the texture coefficient TC (hkl) is defined as follows:

$$TC(hkl) = \frac{I(hkl)}{I_0(hkl)} \left[ \frac{1}{n} \sum_{n-1}^{n} \frac{I(hkl)}{I_0(hkl)} \right]^{-1},$$

wherein

   - I(hkl) are the intensities of the diffraction reflexes, measured by X-ray diffraction,
   - $I_0$(hkl) are the standard intensities of the diffraction reflexes in accordance with PDF chart 00-046-1200,
   - n is the number of reflexes used for the calculation, and
   - the reflexes (111), (200), (220) and (311) are used for the calculation of TC(hkl), wherein the preferential orientation of the crystal growth of the $Ti_{1-x}Al_xC_yN_z$ layer is present with respect to the crystallographic {111}-, {200}-, {220}- or {311}-plane, particularly preferably with respect to the crystallographic {111}-plane.

6. A tool according to one of the preceding claims **characterised in that** the $Ti_{1-x}Al_xC_yN_z$ layer has a preferential orientation of crystal growth with respect to a crystallographic {hkl}-plane, which is **characterised in that** the maximum of the X-ray diffraction peak of the crystallographic {hkl}-plane, measured by X-ray diffraction (XRD) and/or by electron backscatter diffraction (EBSD), is measured within an angle $\alpha = \pm20$ degrees, preferably within an angle $\alpha = \pm10$ degrees, particularly preferably within an angle $\alpha = \pm5$ degrees, quite particularly preferably within an angle $\alpha = \pm1$ degree, relative to the normal to the surface of the base body, wherein the preferential orientation of the crystal growth of the $Ti_{1-x}Al_xC_yN_z$ layer is present with respect to the crystallographic {111}-, {200}-, {220}- or {311}-plane, particularly preferably with respect to the crystallographic {111}-plane.

7. A tool according to one of the preceding claims **characterised in that** the full width at half maximum (FWHM) of at least one of the X-ray diffraction peaks of the crystallographic {111}-, {200}-, {220}- and {311}-planes is <1° 2θ, preferably <0.6° 2θ, particularly preferably <0.45° 2θ, preferably the full width at half maximum (FWHM) of the X-ray diffraction peak of the crystallographic {111}-plane.

8. A tool according to one of the preceding claims **characterised in that** the $Ti_{1-x}Al_xC_yN_z$ layer has a preferential orientation of crystal growth with respect to the crystallographic {111}-plane, which is **characterised by** a ratio of the intensities of the X-ray diffraction peaks of the crystallographic {111}-plane and the {200}-plane, I{111} and I{200}, in which I{111}/I{200} > $1+h(\ln h)^2$, preferably I{111}/I{200} > $1+(h+3)(\ln h)^2$, wherein h is the thickness of $Ti_{1-x}Al_xC_yN_z$ layer in "$\mu$m".

9. A tool according to one of the preceding claims **characterised in that** the $Ti_{1-x}Al_xC_yN_z$ layer has stoichiometry coefficients $0.70 \leq x < 1$, $y = 0$ and $0.95 \leq z < 1.15$.

10. A tool according to one of the preceding claims **characterised in that** the $Ti_{1-x}Al_xC_yN_z$ layer has a Vickers hardness (HV) > 2300 HV, preferably > 2750 HV, particularly preferably > 3000 HV.

11. A tool according to one of the preceding claims **characterised in that** arranged between the base body and the $Ti_{1-x}Al_xC_yN_z$ layer is at least one further hard material layer of a thickness of 0.05 $\mu$m to 7 $\mu$m, preferably 0.1 $\mu$m to 5 $\mu$m, particularly preferably 0.2 $\mu$m to 3 $\mu$m, selected from a TiN layer, a TiCN layer deposited by means of high temperature CVD (CVD) or medium temperature CVD (MT-CVD), an $Al_2O_3$ layer and combinations thereof and/or arranged over the $Ti_{1-x}Al_xC_yN_z$ layer is at least one further hard material layer, preferably at least one $Al_2O_3$ layer of the modification $\gamma$-$Al_2O_3$, $\kappa$-$Al_2O_3$ or $\alpha$-$Al_2O_3$, particularly preferably an $\alpha$-$Al_2O_3$ layer, wherein the $Al_2O_3$ layer is deposited by means of high temperature CVD (CVD) or medium temperature CVD (MT-CVD).

12. A process for the production of a tool according to one of the preceding claims, wherein for producing the $Ti_{1-x}Al_xC_yN_z$ layer with a lamellar structure

    a) the bodies to be coated are placed in a substantially cylindrical CVD reactor designed for an afflux flow of the bodies to be coated with the process gases in a direction substantially radially relative to the longitudinal axis of the reactor,
    b) two precursor gas mixtures (VG1) and (VG2) are provided, wherein the first precursor gas mixture (VG1) contains 0.005% to 0.2 vol-% $TiCl_4$, 0.025% to 0.5 vol-% $AlCl_3$ and as a carrier gas hydrogen ($H_2$) or a mixture of hydrogen and nitrogen ($H_2/N_2$), and the second precursor gas mixture (VG1) contains 0.1 to 3.0 vol-% of at least one N-donor selected from ammonia ($NH_3$) and hydrazine ($N_2H_4$) and as a carrier gas hydrogen ($H_2$) or a mixture of hydrogen and nitrogen ($H_2/N_2$), and the first precursor gas mixture (VG1) and/or the second precursor gas mixture (VG2) optionally contains a C-donor selected from acetonitrile ($CH_3CN$), ethane ($C_2H_6$), ethene ($C_2H_4$) and ethyne ($C_2H_2$) and mixtures thereof, wherein the total vol-% proportion of N-donor and C-donor in the precursor gas mixtures (VG1, VG2) is in the range of 0.1 to 3.0 vol-%,
    c) the two precursor gas mixtures (VG1, VG2) are kept separate before passing into the reaction zone and are introduced substantially radially relative to the longitudinal axis of the reactor at a process temperature in the CVD reactor in the range of 600°C to 850°C and a process pressure in the CVD reactor in the range of 0.05 to 18 kPa,

wherein the volume gas flows ($\dot{V}$) of the precursor gas mixtures (VG1, VG2) are so selected that the mean residence time ($\tau$) in the CVD reactor is less than 1 second.

13. A process according to claim 12 **characterised in that** the volume gas flows ($\dot{V}$) of the precursor gas mixtures (VG1, VG2) are so selected that the mean residence time ($\tau$) in the CVD reactor is less than 0.5 second, preferably less than 0.35 second.

14. A process according to one of claims 12 or 13 **characterised in that** the process temperature in the CVD reactor is in the range of 625°C to 800°C, preferably in the range of 650°C to 725°C, and/or the process pressure in the CVD reactor is in the range of 0.05 to 8 kPa, preferably in the range of 0.1 to 7 kPa.

15. A process according to one of claims 12 to 14 **characterised in that** the ratio of the volume gas flows ($\dot{V}$) of the precursor gas mixtures (VG1, VG2) $\dot{V}$(VG1)/$\dot{V}$(VG2) is less than 1.5, preferably less than 1.25, particularly preferably less than 1.15.

**Revendications**

1. Outil ayant un corps de base en métal dur, cermet, céramique, acier ou acier à coupe rapide et avec un revêtement de protection d'usure en une ou plusieurs couches, déposé selon un procédé de dépôt chimique en phase vapeur et ayant une épaisseur de 3 μm à 25 μm, le revêtement de protection d'usure comprenant au moins une couche de $Ti_{1-x}Al_xC_yN_z$ avec les coefficients de stoechiométrie $0,70 \leq x < 1$, $0 \leq y < 0,25$, $0,75 \leq z < 1,15$ et avec une épaisseur de l'ordre de 1,5 μm à 17 μm, **caractérisé en ce que**

la couche de $Ti_{1-x}Al_xC_yN_z$ présente une structure lamellaire avec des lamelles ayant une épaisseur ne dépassant pas 150 nm, de préférence ne dépassant pas 100 nm et de manière particulièrement préférée ne dépassant pas 50 nm,

- les lamelles étant formées de zones périodiquement alternantes de la couche de $Ti_{1-x}Al_xC_yN_z$ avec des teneurs stoechiométriques différentes en alternance en Ti et en Al, qui ont la même structure cristalline (phase cristallographique) et
- la couche de $Ti_{1-x}Al_xC_yN_z$ comprenant à au moins 90 % en volume une structure cristalline cubique à faces centrées.

2.   Outil selon la revendication 1, **caractérisé en ce que** la couche de $Ti_{1-x}Al_xC_yN_z$ comprend à au moins 95 % en volume, de préférence à au moins 98 % en volume, de manière particulièrement préférée à environ 100 % en volume une structure cristalline cubique à faces centrées.

3.   Outil selon l'une des revendications précédentes, **caractérisé en ce que** dans la couche de $Ti_{1-x}Al_xC_yN_z$ avec des lamelles formées de zones périodiquement alternantes avec des teneurs stoechiométriques différentes en alternance en Ti et en Al, des zones adjacentes ayant d'autres teneurs en Ti et en Al se trouvant, dans la direction de croissance des couches, respectivement en-dessous et au-dessus d'une zone des lamelles, présentent la même orientation cristallographique.

4.   Outil selon l'une des revendications précédentes, **caractérisé en ce que** la couche de $Ti_{1-x}Al_xC_yN_z$ présente une microstructure en colonne, les cristallites en colonne ayant une longueur moyenne qui est au moins 0,35 fois, de préférence au moins 0,5 fois, de manière particulièrement préférée 0,7 fois l'épaisseur de la couche de $Ti_{1-x}Al_xC_yN_z$ et/ou
les cristallites en colonne présentant un rapport entre la longueur moyenne et la largeur moyenne, mesuré à 50 % de l'épaisseur de la couche de $Ti_{1-x}Al_xC_yN_z$, d'au moins 2,5, de préférence d'au moins 5, de manière particulièrement préférée d'au moins 7.

5.   Outil selon l'une des revendications précédentes, **caractérisé en ce que** la couche de $Ti_{1-x}Al_xC_yN_z$ présente une orientation préférée de croissance des cristaux par rapport à un plan cristallographique {hkl}, **caractérisée par** un coefficient de texture TC (hkl) > 1,5, de préférence > 2, de manière particulièrement préférée > 3, le coefficient de texture TC (hkl) étant défini de la manière suivante :

$$TC(hkl) = \frac{I(hkl)}{I_0(hkl)} \left[ \frac{1}{n} \sum_{n-1}^{n} \frac{I(hkl)}{I_0(hkl)} \right]^{-1},$$

- I(hkl) étant les intensités des reflets de diffraction mesurés par diffraction aux rayons X,
- $I_0$(hkl) étant les intensités standard des reflets de diffraction selon la carte pdf 00-046-1200,
- n étant le nombre de reflets utilisés pour le calcul, et
- les reflets (111), (200), (220) et (311) étant utilisés pour le calcul de TC (hkl),

l'orientation préférée de la croissance des cristaux de la couche de $Ti_{1-x}Al_xC_yN_z$ se présentant par rapport au plan cristallographique {111}, {200}, {220} ou {311}, de manière particulièrement préférée par rapport au plan cristallographique {111}.

6.   Outil selon l'une des revendications précédentes, **caractérisé en ce que** la couche de $Ti_{1-x}Al_xC_yN_z$ présente une orientation préférée de la croissance des cristaux par rapport à un plan cristallographique {hkl} qui est **caractérisée par le fait que** le maximum de la pointe de la diffraction aux rayons X du plan cristallographique {hkl}, mesurée par diffractométrie de la diffraction aux rayons X (XRD) et/ou par diffraction par rétrodiffusion d'électrons (EBSD), est mesuré à l'intérieur d'un angle $\alpha = \pm 20$ degrés, de préférence à l'intérieur d'un angle $\alpha = \pm 10$ degrés, de manière particulièrement préférée à l'intérieur d'un angle $\alpha = \pm$ 5 degrés, de manière très particulièrement préférée à l'intérieur d'un angle $\alpha = \pm$ 1 degré, par rapport à la normale de la surface du corps de base, l'orientation préférée de la croissance des cristaux de la couche de $Ti_{1-x}Al_xC_yN_z$ se présentant par rapport au plan cristallographique {111}, {200}, {220} ou {311}, de manière particulièrement préférée par rapport au plan cristallographique {111}.

7. Outil selon l'une des revendications précédentes, **caractérisé en ce que** la largeur à demi-valeur (FWHM) d'au moins une des pointes de diffraction par diffraction aux rayons X des plans cristallographiques {111}, {200}, {220} et {311} est < 1° 2θ, de préférence < 0,6° 2θ, de manière particulièrement préférée < 0,45° 2θ, de préférence la demi-valeur (FWHM) de la pointe de diffraction par diffraction aux rayons X du plan cristallographique {111}.

8. Outil selon l'une des revendications précédentes, **caractérisé en ce que** la couche de $Ti_{1-x}Al_xC_yN_z$ présente une orientation préférée de la croissance des cristaux par rapport au plan cristallographique {111} qui est **caractérisée par** un rapport entre les intensités des pointes de diffraction par diffraction aux rayons X du plan cristallographique {111} et du plan {200}, I{111} ou I{200}, où I{111} / I{200} > 1 + h (ln h)$^2$, de préférence I{111} / I{200} > 1 +(h + 3) x (ln h)$^2$, h étant l'épaisseur de la couche de $Ti_{1-x}Al_xC_yN_z$ en «$\mu$m» .

9. Outil selon l'une des revendications précédentes, **caractérisé en ce que** la couche de $Ti_{1-x}Al_xC_yN_z$ présente des coefficients de stoechiométrie $0,70 \leq x < 1$, $y = 0$ et $0,95 \leq z < 1,15$.

10. Outil selon l'une des revendications précédentes, **caractérisé en ce que** la couche de $Ti_{1-x}Al_xC_yN_z$ présente une dureté Vickers (HV) > 2300 HV, de préférence > 2750 HV, de manière particulièrement préférée > 3000 HV.

11. Outil selon l'une des revendications précédentes, **caractérisé en ce qu'**il est disposé entre le corps de base et la couche de $Ti_{1-x}Al_xC_yN_z$, au moins une autre couche de matière dure ayant une épaisseur de 0,05 $\mu$m à 7 $\mu$m, de préférence de 0,1 $\mu$m à 5 $\mu$m, de manière particulièrement préférée de 0,2 $\mu$m à 3 $\mu$m, choisie parmi une couche de TiN, une couche de TiCN déposée par dépôt chimique en phase vapeur à haute température (CVD) ou à moyenne température (MT-CVD), une couche d'$Al_2O_3$ ou des combinaisons de celles-ci et/ou qu'il est disposé au-dessus de la couche de $Ti_{1-x}Al_xC_yN_z$ une autre couche de matière dure, de préférence au moins une couche d'$Al_2O_3$ de la modification $\gamma$-$Al_2O_3$, $\kappa$-$Al_2O_3$ ou $\alpha$-$Al_2O_3$, de manière particulièrement préférée une couche de $\alpha$-$Al_2O_3$, la couche de $\alpha$-$Al_2O_3$ étant déposée par dépôt chimique en phase vapeur à haute température (CVD) ou à moyenne température (MT-CVD).

12. Procédé de fabrication d'un outil selon l'une des revendications précédentes, selon lequel, pour la fabrication de la couche de $Ti_{1-x}Al_xC_yN_z$ ayant une structure lamellaire,

a) les corps à pourvoir d'un revêtement sont disposés dans un réacteur cylindrique pour CVD qui est adapté pour que les gazes de processus arrivent sur les corps à revêtir dans une direction sensiblement radiale à l'axe longitudinal du réacteur,
b) deux mélanges de gaz précurseurs (VG1) et (VG2) sont mis à disposition, le premier mélange de gaz précurseurs (VG1) contenant 0,005 % à 0,2 % en volume de $TiCl_4$, 0,025 % à 0,5 % en volume d'$AlCl_3$ et comme gaz porteur de l'hydrogène ($H_2$) ou un mélange d'hydrogène et d'azote ($H_2/N_2$), le deuxième mélange de gaz précurseurs (VG2) contenant 0,1 à 0,3 % en volume d'au moins un donneur de N, choisi parmi l'ammoniaque ($NH_3$) et l'hydrazine ($N_2H_4$) et comme gaz porteur de l'hydrogène ($H_2$) ou un mélange d'hydrogène et d'azote ($H_2/N_2$), et le premier mélange de gaz précurseurs (VG1) et/ou le deuxième mélange de gaz précurseurs (VG2) contenant le cas échéant un donneur de C, choisi parmi de l'acétonitrile ($CH_3CN$), de l'éthane ($C_2H_6$), de l'éthène ($C_2H_4$) et de l'éthyne ($C_2H_2$) ou un mélange de ceux-ci, la teneur totale en % en volume des donneurs de N et des donneurs de C dans les mélanges de gaz précurseurs (VG1, VG2) étant de l'ordre de 0,1 à 3,0 % en volume,
c) les deux mélanges de gaz précurseurs (VG1, VG2) sont maintenus séparés avant l'entrée dans la zone de réaction et sont introduits sensiblement radialement à l'axe longitudinal du réacteur à une température de processus dans le réacteur pour CVD dans la plage de 600 °C à 850 °C et à une pression de processus dans le réacteur pour CVD dans la plage de 0,05 à 18 kPa,

les flux volumiques de gaz (V̇) des mélanges de gaz précurseurs (VG1, VG2) étant choisis de façon que le temps moyen de séjour ($\tau$) dans le réacteur pour CVD soit inférieur à 1 seconde.

13. Procédé selon la revendication 12, **caractérisé en ce que** les flux volumiques de gaz (V̇) des mélanges de gaz précurseurs (VG1, VG2) sont choisis de façon que le temps moyen de séjour ($\tau$) dans le réacteur pour CVD soit inférieur à 0,5 seconde, de préférence inférieur à 0,35 seconde.

14. Procédé selon l'une des revendications 12 ou 13, **caractérisé en ce que** la température de processus dans le réacteur pour CVD est dans la plage de 625 °C à 800 °C, de préférence dans la plage de 650 °C à 725 °C et/ou que la pression de processus dans le réacteur pour CVD est dans la plage de 0,05 à 8 kPa, de préférence dans la plage de 0,1 à 7 kPa.

15. Procédé selon l'une des revendications 12 à 14, **caractérisé en ce que** le rapport des flux volumiques de gaz (V̇) des mélanges de gaz précurseurs (VG1, VG2) V̇(VG1) / V̇(VG2) est inférieur à 1,5, de préférence inférieur à 1,25, de manière particulièrement préférée inférieur à 1,15.

| 1 µm | EHT = 2.50 kV | Signal A = SE2 | Mag = 20.00 K |
| | WD = 5.4 mm | | |

**Figur 1**

| 200 nm | EHT = 2.50 kV | | Mag = 20.00 K X |
| | WD = 4.5 mm | | |

**Figur 2**

(A)                                              (B)

Figur 3

Figur 4

(A)

(B)

(C)

(D)

**Figur 5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2013134796 A
- WO 2012126030 A
- DE 102005032860
- DE 102007000512
- WO 2009112115 A
- WO 2009112116 A
- WO 2009112117 A1
- US 20090274899 A
- US 20090074521 A
- WO 2009127344 A

**In der Beschreibung aufgeführte Nicht-Patentliteratur**

- **J. KECKES et al.** Self-organized periodic soft-hard nanolamellae in polycrystalline TiAlN thin films. *Thin Solid Films,* 2013, vol. 545, 29-32